# EUROPEAN PATENT APPLICATION

(11) **EP 4 822 068 A1**
(43) Date of publication of application: **14.10.2026**
(21) Application number: 24900363.3
(22) Date of filing: 07.11.2024
(51) Int. Cl.: C30B 29/04, C01B 32/25, C30B 1/12

(54) **DIAMOND**

(30) Priority: 04.12.2023 JP 2023204540
(71) Applicant: Sumitomo Electric Industries, Ltd., Osaka-shi, Osaka 541-0041 (JP)
(72) Inventor: NISHIBAYASHI, Yoshiki, Osaka-shi, Osaka 541-0041 (JP); KOBAYASHI, Yutaka, Osaka-shi, Osaka 541-0041 (JP); TSUJI, Hirokazu, Osaka-shi, Osaka 541-0041 (JP)
(74) Representative: Boult Wade Tennant LLP
(86) International application number: PCT/JP2024/039579
(87) International publication number: WO 2025/121068

(57) **Abstract**

Provided is a diamond having a content based on a number of atoms of ¹⁴C of 0.3 ppt or more and 3.0 ppt or less.

## Description

### TECHNICAL FIELD

The present disclosure relates to a diamond. The present application claims priority based on Japanese Patent Application No. 2023-204540 filed on December 4, 2023. The entire contents described in the Japanese patent application are incorporated herein by reference.

### BACKGROUND ART

Diamonds used for industrial products and jewelry include natural diamond and synthetic diamond. Natural diamond is made from carbon derived from ancient creatures and ancient plants existing deep underground. A carbon source for synthetic diamond is generally produced from fossil fuel such as graphite (for example, PTL 1).

### CITATION LIST

### PATENT LITERATURE

PTL 1: Japanese Patent Laying-Open No. H2-17934

### SUMMARY OF INVENTION

A diamond of the present disclosure is a diamond having a content based on a number of atoms of ¹⁴C of 0.3 ppt or more and 3.0 ppt or less.

### BRIEF DESCRIPTION OF DRAWINGS

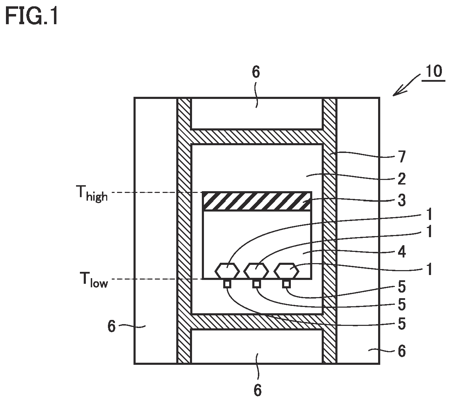

[Fig. 1] Fig. 1 is a schematic cross sectional view showing an example of a configuration of a sample chamber used for manufacturing a diamond according to one embodiment of the present disclosure.

### DETAILED DESCRIPTION

### [Problem to be Solved by the Present Disclosure]

In recent years, from the viewpoint of improving the global environment, various efforts have been made toward achieving carbon neutrality that makes the emission amount of greenhouse gas such as carbon dioxide zero as a whole. In diamonds as well, techniques capable of contributing to the achievement of carbon neutrality are required.

Accordingly, an object of the present disclosure is to provide a diamond capable of contributing to the achievement of carbon neutrality.

### [Advantageous Effect of the Present Disclosure]

According to the present disclosure, it is possible to provide a diamond capable of contributing to the achievement of carbon neutrality.

### [Description of Embodiments of the Present Disclosure]

First, embodiments of the present disclosure will be listed and described.
(1) A diamond of the present disclosure is a diamond having a content based on a number of atoms of ¹⁴C of 0.3 ppt or more and 3.0 ppt or less.
   According to the present disclosure, it is possible to provide a diamond capable of contributing to the achievement of carbon neutrality.
(2) In (1) described above, the content based on the number of atoms of the ¹⁴C may be 0.6 ppt or more and 1.5 ppt or less. This indicates that the diamond is a diamond in which carbon circulated from the atmosphere in recent years is fixed. When compared with carbon directly captured from the atmosphere, carbon derived from plants has a slightly lower ¹⁴C concentration, because it also contains carbon through the ground.
(3) In (1) or (2) described above, the diamond may have a content based on the number of atoms of ¹³C of 0.8% or more and 1.5% or less. This indirectly and supplementarily indicates that the diamond is a diamond in which carbon circulated from the atmosphere in recent years is fixed.
(4) In (3) described above, the content based on the number of atoms of the ¹³C may be 1.0% or more and 1.2% or less. This further proves that the diamond is a diamond in which carbon circulated from the atmosphere in recent years is fixed.
(5) In any one of (1) to (4) described above, the diamond may contain at least one selected from the group consisting of phosphorus, potassium, and calcium, and a total content based on the number of atoms of the phosphorus, the potassium, and the calcium in the diamond may be 1 ppb or more.
   Phosphorus, potassium, and calcium are contained in plants growing on the ground. Accordingly, when the diamond contains phosphorus, potassium, and calcium, it indicates that the diamond uses plants growing on the ground as a raw material.
(6) In any one of (1) to (5) described above, the diamond may have a maximum diameter of 1 mm or more. Thereby, the diamond can be easily used for various applications.
(7) In any one of (1) to (6) described above, a half-width of an X-ray diffraction rocking curve of the diamond may be 15 seconds or less, The half-width of the X-ray diffraction rocking curve is measured with CuKα rays in X-ray diffraction by a double crystal method, using a diamond crystal as a first crystal, with (004) planes being arranged in parallel.
   This indicates that the diamond has a high crystallinity and less crystal defects and distortion, and is a diamond with a higher utility value.
(8) In any one of (1) to (7) described above, a number of defects confirmed in an X-ray topography image of the diamond may be 100 defects/cm² or less. This indicates that the diamond has less crystal defects and distortion, and is a diamond with a higher utility value.
(9) In any one of (1) to (8) described above, an average of phase differences per unit thickness of the diamond may be 10 nm/mm or less. This indicates that the diamond has less crystal defects and distortion, and is a diamond with a higher utility value.
(10) In any one of (1) to (9) described above, a half-width of a peak at a Raman shift of 1332 cm⁻¹ or more and 1333 cm⁻¹ or less in a Raman spectroscopy spectrum of the diamond may be 3.0 cm⁻¹ or less. This indicates that the diamond can have a high crystallinity, and is a diamond with a higher utility value.
(11) In any one of (1) to (10) described above, a transmittance of light with a wavelength of 270 nm of the diamond may be 70% or more. Thereby, the value as a heat dissipating material requiring heat conductivity or a window material and jewelry requiring transparency of a diamond increases, and the amount of diamonds used increases, which contributes to the reduction of CO₂ in the atmosphere.
(12) In any one of (1) to (11) described above, in a photoluminescence spectrum of the diamond, a maximum light emission peak may exist within a range in wavelength of 490 nm or more and 510 nm or less. Thereby, the value as a heat dissipating material requiring heat conductivity or a window material and jewelry requiring transparency of a diamond increases, and the amount of diamonds used increases, which contributes to the reduction of CO₂ in the atmosphere.
(13) In any one of (1) to (12) described above, the diamond may contain two or more types of growth sectors different from each other. The existence of two or more types of different growth sectors in the diamond indicates that a diamond obtained by grain growth is fully utilized and that a diamond larger than a seed crystal is successfully synthesized, and proves that more carbon can be fixed.
(14) In any one of (1) to (13) described above, the diamond may not contain an inclusion. In terms of characteristics, an inclusion is a characteristic that impairs heat dissipation properties, optical identification, and appearance of a product which uses a diamond. Accordingly, when the diamond does not contain an inclusion, the value of the product increases.

### [Details of Embodiments of the Present Disclosure]

Hereinafter, a specific example of the diamond of the present disclosure will be described with reference to the drawings. In the drawings of the present disclosure, the same reference numerals designate the same or corresponding parts. Further, dimensional relations in length, width, thickness, depth, and the like are changed as appropriate for clarity and simplicity of the drawings, and do not necessarily represent actual dimensional relations.

In the present specification, an expression in the form of "A to B" means lower and upper limits of a range (that is, A or more and B or less), and when A is not accompanied by any unit and B is alone accompanied by a unit, A has the same unit as B.

The present inventors studied raw materials for synthetic diamond in order to provide a diamond capable of contributing to the achievement of carbon neutrality. Generally, carbon derived from fossil fuel such as graphite is used as a raw material for synthetic diamond. Since carbon derived from fossil fuel can be highly purified, it is easy to stably synthesize diamonds therefrom, but producing diamonds from carbon derived from fossil fuel does not contribute to the reduction of carbon dioxide in the atmosphere. On the other hand, carbon constituting plants currently growing on the ground is derived from carbon dioxide in the atmosphere. Thus, these carbon sources do not have high purity and density, and it is usually difficult to stably synthesize diamonds therefrom. However, if diamonds can be produced using plants growing on the ground as a raw material, carbon dioxide in the atmosphere can be reduced, which can contribute to the achievement of carbon neutrality. As a result of earnest studies, the present inventors have found a technique of producing diamonds using plants growing on the ground as a raw material, and have completed the diamond of the present disclosure. Hereinafter, the diamond of the present disclosure will be described.

### [First Embodiment: Diamond]

A diamond according to one embodiment (hereinafter also referred to as a "first embodiment") of the present disclosure is a diamond having a content based on a number of atoms of ¹⁴C of 0.3 ppt or more and 3.0 ppt or less.

Three carbon isotopes, ¹²C, ¹³C, and ¹⁴C, exist in nature. ¹⁴C is radiocarbon with a half-life of 5730 years. The content of ¹⁴C in carbon contained in carbon dioxide in the atmosphere is higher than the content of ¹⁴C in carbon contained in fossil fuel. Specifically, during a normal active period of the sun, the content of ¹⁴C in carbon contained in carbon dioxide in the atmosphere is about 0.9 ppt or more. The content of ¹⁴C in organic matter in soil which contains carbon contained in carbon dioxide in the atmosphere in a circulated form, and the content of ¹⁴C in carbon derived from trees up to 7000 years old (such as the Jomon Cedar) and plants growing using carbon dioxide in the atmosphere are about 0.3 ppt or more, although they may have grown during solar minimums and the like. **In** contrast, the content of ¹⁴C in carbon contained in fossil fuel is less than about 0.1 ppt. Therefore, it is possible to determine whether a raw material for a diamond contains carbon derived from carbon dioxide in the atmosphere, on the basis of the content based on the number of atoms of ¹⁴C in the diamond.

The diamond of the first embodiment has a content based on the number of atoms of ¹⁴C (hereinafter also referred to as a "content of ¹⁴C") of 0.3 ppt or more and 3.0 ppt or less. When the diamond has a content of ¹⁴C of 0.3 ppt or more and 3.0 ppt or less, it indicates that the raw material for the diamond contains carbon derived from carbon dioxide in the atmosphere, and that the diamond is a diamond in which carbon circulated from the atmosphere in recent years is fixed. Accordingly, the diamond of the first embodiment can contribute to the achievement of carbon neutrality.

### <Content of ¹⁴C>

The content based on the number of atoms of ¹⁴C in the diamond of the first embodiment is 0.3 ppt or more and 3.0 ppt or less, and may be 0.30 ppt or more and 3.0 ppt or less, may be 0.6 ppt or more and 2.0 ppt or less, or may be 0.9 ppt or more and 1.5 ppt or less.

**In** the present disclosure, the content based on the number of atoms of ¹⁴C in the diamond is measured using accelerator mass spectrometry (AMS: accelerator mass spectrometry). The AMS is a method known as a dating method using the carbon isotopes.

### <Content of ¹³C>

A content based on the number of atoms of ¹³C in the diamond of the first embodiment may be 0.8% or more and 1.5% or less, may be 0.9% or more and 1.3% or less, or may be 1.0% or more and 1.2% or less.

**In** the present disclosure, the content based on the number of atoms of ¹³C in the diamond is measured by secondary ion mass spectrometry (SIMS: secondary ion mass spectrometry).

### <Phosphorus, Potassium, and Calcium>

The diamond of the first embodiment can contain at least one selected from the group consisting of phosphorus, potassium, and calcium.

A total content based on the number of atoms of phosphorus, potassium, and calcium in the diamond of the first embodiment may be 1 ppb or more, may be 1 ppb or more and 2000 ppb or less, may be 10 ppb or more and 1500 ppb or less, or may be 100 ppb or more and 1000 ppb or less.

In the present disclosure, a method for measuring the total content based on the number of atoms of phosphorus, potassium, and calcium in the diamond is as follows. It is measured by secondary ion mass spectrometry (SIMS).

### <Maximum Diameter>

A maximum diameter of the diamond of the first embodiment may be 1 mm or more, may be 1 mm or more and 50 mm or less, may be 2 mm or more and 50 mm or less, or may be 3 mm or more and 50 mm or less.

In the present disclosure, the maximum diameter of the diamond means a maximum value of a length of a straight line connecting two different points provided on a surface of the diamond. The maximum diameter of the diamond is measured with an optical microscope having a length measuring function.

### <Half-width of X-ray Diffraction Rocking Curve>

A smaller half-width of an X-ray diffraction rocking curve of the diamond indicates that the diamond has a higher crystallinity and less crystal defects and distortion.

The half-width of the X-ray diffraction rocking curve of the diamond of the first embodiment may be 15 seconds or less, may be 4 seconds or more and 15 seconds or less, may be 4 seconds or more and 10 seconds or less, may be 4 seconds or more and 8 seconds or less, or may be 4 seconds or more and 6 seconds or less.

The half-width of the X-ray diffraction rocking curve of the diamond is measured with CuKα rays in X-ray diffraction by a double crystal method, using a diamond crystal as a first crystal, with (004) planes being arranged in parallel. Thereby, a half-width of an X-ray diffraction rocking curve of a (001) plane of the diamond is measured. **In** the double crystal method, diamond crystals cut out from the diamond to be measured are used as the first crystal and a second crystal. The first crystal plays a role of a monochromator. Crystallinities of both the first crystal and the second crystal are reflected in the half-width of the rocking curve. Accordingly, when both the first crystal and the second crystal are diamond crystals cut out from the diamond to be measured, the half-width of the rocking curve is a value that sensitively reflects the quality of crystallinity of a sample.

The half-width of the X-ray diffraction rocking curve of the diamond may be measured with a device that uses four Ge crystals. **In** this case, since a half-width of the four Ge crystals is included, it is necessary to subtract this half-width by separation of Gaussian distributions to calculate a half-width of only the diamond, and multiply it by √2 so as to correspond to the result of two diamond crystals.

**In** the diamond of the first embodiment, it has been confirmed that there is no variation in results even when the above measurement is performed in different regions.

### <Number of Defects>

Examples of defects contained in diamonds include point defects such as vacancies, needle-like defects extending linearly, impurities, stacking faults, distortion, and the like. Among these defects, the existence of linear defects and stacking faults is confirmed in an X-ray topography image. Since these defects have higher X-ray reflection intensities than that of a portion of a crystal other than these defects (a portion with fewer defects, that is, a portion with a high crystallinity), the existence thereof is shown in the X-ray topography image, as dark portions in the case of a positive image, and as bright portions in the case of a negative image. **In** the present disclosure, the number of defects is an index indicating a defect amount derived from the number of linear defects in the diamond.

The number of defects in the diamond of the first embodiment may be 100 defects/cm² or less, may be 0 defects/cm² or more and 100 defects/cm² or less, may be 0 defects/cm² or more and 10 defects/cm² or less, or may be 0 defects/cm².

To obtain the X-ray topography image of the diamond, the diamond is measured in a transmission mode, using X-rays with a wavelength of 0.71 Å, and using (220) diffraction at 2θ = 32.9°.

### <Phase Difference>

Since a diamond is an isotropic crystal, it usually has an isotropic refractive index (dielectric constant). On the other hand, when defects and distortion exist in the diamond, the diamond has a birefringence. When a defect in the diamond is irradiated with circularly polarized light, a phase difference occurs between beams of the polarized light along a slow axis and a fast axis, and the circularly polarized light is emitted as elliptically polarized light (including linearly polarized light). If the refractive index is not isotropic due to defects and distortion in a diamond crystal, a polarization direction in which the beam is slowest (the slow axis) and a polarization direction in which the beam is fastest (the fast axis) are generated. On the other hand, when a portion other than the defect, which maintains an isotropic refractive index, is irradiated with circularly polarized light, no phase difference occurs, and the circularly polarized light is emitted as it is. By obtaining directions of a major axis and a minor axis of an ellipse in the elliptically polarized light and a ratio between lengths of the major axis and the minor axis, an optical axis and the phase difference can be obtained. Further, by combining a lens and a microscope, information on a local phase difference in a microscopic portion can be obtained. Further, by arranging an integrated polarizer in front of pixels of a digital detector, information in each pixel (that is, information on a local position of a sample) can be obtained two-dimensionally.

The phase difference measured for each local position is a value integrated in a plate thickness direction of a substrate. Accordingly, comparison is performed between samples with the same plate thickness, or by standardizing the phase difference by the plate thickness. In the case of standardizing the phase difference by the plate thickness, the phase difference is indicated as a phase difference converted to a thickness of 1 mm (unit: nm/mm). For example, for conversion to a thickness of 1 mm, a value measured at a thickness of 0.1 mm is multiplied by 10, a value measured at a thickness of 0.2 mm is multiplied by 5, and a value measured at a thickness of 0.5 mm is multiplied by 2.

The value of a two-dimensional phase difference indicates a distribution in a substrate surface. As a method for expressing characteristics of the substrate, it is appropriate to represent them by an average value of phase differences in an arbitrary surface of the substrate. The average value of the phase differences in the substrate means an average value of phase differences in an effective area within the size of the substrate. Here, the effective area means an area portion excluding an edge portion, because the value of the phase difference cannot be measured accurately at an edge of the substrate. More accurately, when a distance from the center of gravity of a main surface of the substrate to the edge is 100%, the effective area is defined as an area within a range with a distance of up to 90% from the center of gravity. Here, the average value of the phase differences in the effective area does not mean a phase difference per area, but is a value obtained by averaging phase differences in local portions over the surface, and is an average of frequency distributions in the surface of the phase differences. Therefore, the average value of the phase differences is also indicated in units of nm/mm.

Even when the amount of crystal defects is constant, as the substrate has a larger thickness, the phase difference accumulates and increases. Further, as the substrate has a larger area, the influence of defects on the entire surface increases, and thus the phase difference increases. For such reasons, as the phase difference converted to a unit thickness is smaller, and/or as the phase difference of the average of the frequency distributions in the surface is smaller, the diamond has a better quality. Further, even when the phase difference is the same, as the substrate is larger, the diamond has a better quality. This is because, when the substrate is cut small, stress is relaxed and the phase difference decreases. As parameters of the quality of distortion, the magnitude of the phase difference and the magnitude of the size of the substrate have an influence.

The value of the phase difference indicates a positive correlation with the defect amount and the magnitude of distortion in the diamond. An average of phase differences per unit thickness of the diamond of the first embodiment is 10 nm/mm or less, and may be 0 nm/mm or more and 10 nm/mm or less, may be 0.01 nm/mm or more and 5 nm/mm or less, or may be 0.01 nm/mm or more and 2 nm/mm or less.

A phase difference per unit thickness of the diamond is measured by the following procedure. First, the diamond is processed into a plate shape having a thickness of 0.1 to 5 mm. As a processing method, laser processing, polishing, plasma etching, ion etching, or a combination thereof can be used. A value converted to a thickness of 1 mm of the diamond is the phase difference per unit thickness.

Next, measurement of the phase difference of the diamond is performed using a birefringence distribution measurement device ("WPA-micro" (trademark) or "WPA-100" (trademark) manufactured by Photonic Lattice, Inc.). Generally, it is difficult to distinguish the phase difference when it exceeds 90 degrees (1/4 of a wavelength). However, the above birefringence distribution measurement device adopts an integrated wave plate system instead of an integrated polarizer system, and thus a measurement range is extended to a phase difference of 180 degrees (1/2 of the wavelength). It should be noted that, it has been experimentally verified that, when three types of wavelengths (one central wavelength and two wavelengths in proximity thereto) are used, the measurement range is extended to 5 to 6 times the wavelength. Measurement values obtained using the above birefringence distribution measurement device are processed using software ("PA-View" (trademark) manufactured by Photonic Lattice, Inc.) to obtain an average of phase differences per unit thickness.

In the same diamond, the above measurement device measures surface distributions to calculate an average in the surface, and thus the average is not influenced by the arrangement of the measurement or the like. It has been confirmed that there is no variation in measurement results even when locations of setting the above measurement regions are arbitrarily changed.

### <Raman Spectroscopy Spectrum>

As a diamond phonon peak appearing at a Raman shift of 1332 cm⁻¹ or more and 1333 cm⁻¹ or less in a Raman spectroscopy spectrum of a diamond is sharper and has a smaller half-width, the diamond has a higher crystallinity.

A half-width of a peak at a Raman shift of 1332 cm⁻¹ or more and 1333 cm⁻¹ or less in a Raman spectroscopy spectrum (hereinafter also referred to as a "half-width of a peak in a Raman spectroscopy spectrum") of the diamond of the first embodiment may be 3.0 cm⁻¹ or less, may be 1.6 cm⁻¹ or more and 2.0 cm⁻¹ or less, may be 1.6 cm⁻¹ or more and 1.8 cm⁻¹ or less, or may be 1.6 cm⁻¹ or more and 1.7 cm⁻¹ or less.

In the present disclosure, the half-width of the peak in the Raman spectroscopy spectrum is measured by the following procedure. First, a surface of the (001) plane of the diamond, which is a measurement sample, is polished with a metal bond grindstone so as to have a surface roughness Ra of 20 nm or less. Preferably, the measurement sample has a shape mainly close to a square or an octagon. The polished surface is irradiated with a laser under the following conditions, to detect a scattered Raman line.

### <<Measurement Conditions>>

Measurement device: LabRAM HR-800 (manufactured by HORIBA JOBIN YVON)
Laser wavelength: 532 nm
Measurement temperature: Room temperature (20°C or more and 25°C or less)

Wavenumber resolution: A value measured under a condition of 0.5 cm⁻¹ or less is defined as the half-width of the peak in the Raman spectroscopy spectrum of the diamond of the first embodiment. If a half-width derived from a light source and the device is 0.5 cm⁻¹ or less, the measured value can be regarded as a half-width inherent to the diamond, without being influenced by the resolution of the device. The half-width derived from the light source and the device can be determined by measuring a half-width of a laser beam used for excitation light. It should be noted that, when the half-width derived from the light source and the device is more than 0.5 cm⁻¹ and 3.0 cm⁻¹ or less, the half-width can be converted to the half-width inherent to the diamond by subtracting the square of the half-width derived from the light source and the device from the square of the measured value of the half-width, and using the square root of that value. When the half-width derived from the light source and the device is more than 3.0 cm⁻¹, accuracy decreases, which is not preferable.
Laser irradiation direction: Vertical incidence when the (001) plane of the diamond is cut out
Laser irradiation position (measurement region): Raman lines are detected at the following five locations (i) to (v).
   (i) A Raman line is detected at a central portion of the polished surface of the measurement sample (the position of the center of gravity in a two-dimensional surface).
   (ii) A straight line is drawn from the central portion to an edge portion of the polished surface, to specify a position P where the straight line has a maximum length. When a distance from the central portion to P is D1, a Raman line is detected at a position where a distance from the central portion is (3/4) D1, on a line segment from the central portion to P.
   (iii) A straight line is drawn from the central portion in a direction opposite to P, to specify an intersection point Q between the straight line and the edge portion of the polished surface. That is, P, the central portion, and Q exist on the same straight line L1. When a distance from the central portion to Q is D2, a Raman line is detected at a position where a distance from the central portion is (3/4) D2, on a line segment from the central portion to Q.
   (iv) A straight line L2 that passes through the central portion and is perpendicular to straight line L1 that passes through P, the central portion, and Q is drawn, to specify intersection points R and S between straight line L2 and the edge portion of the polished surface. When a distance from the central portion to R is D3, a Raman line is detected at a position where a distance from the central portion is (3/4) D3, on a line segment from the central portion to R.
   (v) When a distance from the central portion to S is D4, a Raman line is detected at a position where a distance from the central portion is (3/4) D4, on a line segment from the central portion to S.

Spectrum analysis is performed on the Raman line detected at each of the five locations, to specify a diamond phonon peak appearing at a Raman shift of 1332 cm⁻¹ or more and 1333 cm⁻¹ or less. A Lorentz function is fitted to the diamond phonon peak by a least squares method, to obtain a half-width of a peak at each of the five locations at a Raman shift of 1332 cm⁻¹ or more and 1333 cm⁻¹ or less. An average of the half-widths of the peaks at the five locations is determined. In the present disclosure, the value of the average corresponds to the half-width of the peak in the Raman spectroscopy spectrum.

In the same diamond, crystallinity such as distortion of the sample can be uniquely evaluated by the method of setting the measurement regions at the above five locations and calculating the average, and can be compared between samples.

### <Transmittance of Light with Wavelength of 270 nm>

A transmittance of light with a wavelength of 270 nm of the diamond of the first embodiment may be 70% or more, may be 85% or more, or may be 95% or more. The transmittance is measured with a UV-visible transmittance spectrophotometer. This transmittance means a net transmittance of the substrate excluding a reflectance. Generally, a diamond has a reflectance of about 28%, and an ideal substrate without absorption has a transmittance of about 72%. This transmittance means a transmittance relative to an ideal value excluding the reflectance.

### <Photoluminescence Spectrum>

In a photoluminescence spectrum of the diamond of the first embodiment, a maximum light emission peak may exist within a range in wavelength of 490 nm or more and 510 nm or less. The photoluminescence spectrum of the diamond is measured with a fluorescence spectrometer or a Raman spectrometer. The maximum peak means a peak having the highest peak intensity among spectra that emit light. It is essential that an excitation wavelength is shorter than 490 nm, and excitation light with a wavelength of 340 nm ± 20 nm is preferable. For example, it is confirmed that a maximum peak wavelength of photoluminescence (a **PL** peak) in a wavelength range from 400 nm to 700 nm when the diamond is irradiated with 325 nm excitation laser light exists within the range in wavelength of 490 nm or more and 510 nm or less. The irradiation direction of the excitation light is vertical incidence when the (001) plane of the diamond is cut out.

### <Growth Sector>

The diamond of the first embodiment may contain two or more types of growth sectors different from each other. The fact that the diamond contains two or more types of growth sectors different from each other is confirmed by observing a fluorescence image with a two-dimensional fluorescence distribution evaluation device, or a fluorescence microscope (for example, "Diamond View" (trademark) manufactured by Diamond Trading Company).

### <Inclusion>

The diamond of the first embodiment may not contain an inclusion. The inclusion means an included substance made of a non-diamond component including graphite or another element such as Fe, Co, or Si observed as a black mass with an optical microscope. **In** particular, an inclusion having a diameter of 10 µm or more observed with a low-magnification optical microscope particularly have an influence on the identification of a diamond, and thus may not be contained.

When a diamond is observed at a magnification of 40 times with the optical microscope and a black dot is not observed, it is determined that the diamond does not contain an inclusion.

### <Types of Crystal>

The diamond of the first embodiment may be a monocrystalline diamond. Thereby, the diamond has high heat dissipation properties, a high transmittance, and less inclusions.

The diamond of the first embodiment may be a polycrystalline diamond. Thereby, it is possible to obtain a large-sized diamond, and more carbon can be fixed.

### <Nitrogen>

The diamond of the first embodiment may contain nitrogen. A nitrogen content in the diamond may be 0.0001 ppm or more and 200 ppm or less, may be 0.001 ppm or more and 10 ppm or less, or may be 0.005 ppm or more and 1 ppm or less.

The nitrogen content in the diamond is measured by secondary ion mass spectrometry (SIMS) or ESR.

### <Applications>

The diamond of the first embodiment can be used for the same applications as those for which conventional diamonds are used, such as tools, jewelry, optical components, semiconductor substrates, and heat dissipation components.

### [Second Embodiment: Method for Manufacturing Diamond]

An example of a method for manufacturing the diamond of the first embodiment will be described below. The diamond of the first embodiment can be produced by a temperature difference method, using a sample chamber having a configuration shown in Fig. 1, for example.

As shown in Fig. 1, in a sample chamber 10 used for manufacturing the diamond of the first embodiment, an insulator 2, a carbon source 3, a solvent metal 4, and a seed crystal 5 are arranged in a space surrounded by a graphite heater 7, and a pressure medium 6 is arranged outside graphite heater 7. The temperature difference method is a synthesis method for growing a diamond on seed crystal 5, by providing a vertical temperature gradient inside sample chamber 10, arranging carbon source 3 at a high-temperature portion (T_{high}), arranging seed crystal 5 for the diamond at a low-temperature portion (T_{low}), arranging solvent metal 4 between carbon source 3 and seed crystal 5, and keeping the inside of sample chamber 10 under conditions of a temperature equal to or higher than a temperature at which solvent metal 4 melts, and a pressure equal to or higher than a pressure at which the diamond becomes thermally stable.

As carbon source 3, Binchotan charcoal produced from plants less than 7000 years old is used. A carbon source made of Binchotan charcoal is produced by the following procedure. First, raw woods dried at room temperature are prepared. The raw woods are roasted in a furnace at a low temperature slowly over five days or more to sufficiently reduce moisture. Thereafter, while supplying a mixed gas obtained by adding a small amount of oxygen to an inert gas into the furnace, the raw woods are quickly baked at 1200 to 1300°C to be carbonized, to obtain charcoal. Thereafter, the charcoal is immediately taken out of the furnace and covered with finely crushed dry ice to rapidly lower the temperature of the charcoal. Thereafter, the charcoal is confined in a vacuum of a dry pump for 24 hours, and is returned to atmospheric pressure with an inert gas such as Ar. Thereby, Binchotan charcoal as a raw material is produced. Thereafter, the Binchotan charcoal is crushed in a ball mill to form powder. The powder is pressed and solidified to form a carbon source.

The carbon source produced by the above method has a density of 1.8 g/cm³ or more and a volume-based porosity of 20% or less. If the carbon source has a density of less than 1.8 g/cm³, the pressure during diamond synthesis is not stable, which poses a problem for the synthesis.

By using the Binchotan charcoal produced by the above method as the carbon source, it is possible to produce the diamond of the first embodiment having a content based on the number of atoms of ¹⁴C of 0.3 ppt or more and 3.0 ppt or less.

As solvent metal 4, iron (Fe) and cobalt (Co) can be used. A mixing ratio of iron and cobalt is set to Fe/Co = 10/90 to 90/10.

Titanium (Ti) or aluminum (Al) may be added as a nitrogen getter to the solvent metal. A content of titanium or aluminum in the solvent metal can be set to 1.5% by mass or more and 3% by mass or less. By adding a nitrogen getter to the solvent metal, the nitrogen content in the diamond can be decreased. When a nitrogen getter is not used, the nitrogen content in the diamond is about the same as that in a type Ib diamond.

Conditions of a high-temperature and high-pressure method are as follows. A temperature gradient is adjusted such that a temperature difference between the high-temperature portion at which carbon source 3 is arranged and the low-temperature portion at which seed crystal 5 is arranged is 10°C or more and 25°C or less, and the inside of sample chamber 10 is kept at a pressure of 5.0 GPa or more and 5.8 GPa or less, and a temperature of the low-temperature portion of 1300°C or more and 1600°C or less, for 80 hours or more and 250 hours or less. A change in temperature during keeping is controlled within ±3°C. Thereby, a monocrystalline diamond grows on the seed crystal.

If the temperature difference between carbon source 3 and seed crystal 5 exceeds 25°C, crystal growth is disturbed and a desired diamond cannot be obtained. If the temperature difference is less than 10°C, a long time is required to grow a crystal having a predetermined size, and only a small diamond can be synthesized. If the change in temperature is larger than ±3°C, crystal growth becomes unstable, crystal defects, distortion, mixing of an inclusion, and the like occur, and a diamond has a reduced crystallinity.

If the carbon source contains an element other than carbon (for example, a mineral) in a large amount, it becomes difficult to synthesize a monocrystalline diamond itself, and it becomes difficult to produce a monocrystalline diamond having a narrow half-width of an X-ray diffraction rocking curve, or a smaller number of defects confirmed in an X-ray topography image, or a small phase difference, or a small Raman half-width, or a low transmittance of a wavelength of 270 nm. Accordingly, the carbon source formed by pressing and solidifying the powder preferably has a porosity of 20% or less.

### EXAMPLES

The present embodiment will be described more specifically with reference to examples. However, the present embodiment is not limited by these examples.

### [Production of Diamond]

A diamond of each sample was synthesized by the temperature difference method using a solvent metal, using a sample chamber having the configuration shown in Fig. 1.

As carbon sources, Binchotan charcoal, high-purity graphite manufactured by Toyo Tanso, and common charcoal were prepared. The type of carbon source used in each sample is as shown in the column "Carbon Source" in Table 1.

The carbon source made of Binchotan charcoal was produced by the following procedure. Dried raw woods were prepared. The temperature of the raw woods was raised in a furnace at 200°C for five days to sufficiently reduce moisture. Thereafter, while supplying a mixed gas obtained by adding oxygen to Ar gas into the furnace, the raw woods were quickly baked at 1200 to 1300°C to be carbonized, to obtain charcoal. An oxygen content in the mixed gas was 1% by volume.

Thereafter, the charcoal was immediately taken out of the furnace and covered with finely crushed dry ice to rapidly lower the temperature of the charcoal. Thereafter, the charcoal was confined in a vacuum of a dry pump for 24 hours, and was returned to atmospheric pressure with an inert gas such as Ar, to produce Binchotan charcoal. Thereafter, the Binchotan charcoal was crushed in a ball mill to form powder, and the powder was pressed and solidified to form a carbon source.

Powder of the high-purity graphite manufactured by Toyo Tanso was pressed to form a carbon source. The common charcoal was used as it was as a carbon source.

The density of the carbon source used in each sample is shown in the column "Carbon Source Density" in Table 1.

Next, the solvent metal was prepared. Iron (Fe) powder, cobalt (Co) powder, and titanium (Ti) powder were prepared at a mass ratio of Fe:Co:Ti = 58:39:3, and were mixed for about one hour with a mixer, to obtain mixed powder. The mixed powder was pelletized by a press machine to produce a pellet-shaped solvent metal. The solvent metal was heated at 1000°C for 30 minutes in a vacuum to perform degassing. Thereafter, the solvent metal and the carbon source were set in a container. The carbon source was arranged at a high-temperature portion in the sample chamber.

The temperature in the sample chamber was adjusted with a graphite heater such that a temperature difference between the high-temperature portion at which the carbon source was arranged and a low-temperature portion at which a seed crystal was arranged was 20°C. Using an ultra-high pressure generation device, the inside of the sample chamber was kept at 5.4 GPa and a temperature of the low-temperature portion of 1340°C for 150 hours, to grow a diamond on the seed crystal. The diamond was a monocrystalline diamond.

### [Table 1]

**Table 1**

| Sample No. | Manufacturing Process | | Diamond | | | | |
|---|---|---|---|---|---|---|---|
| | Carbon Source | Carbon Source Density | ¹⁴C Content | ¹³C Content | P Content | K Content | Ca Content |
| | | g/cm³ | ppt | % | ppb | ppb | ppb |
| 1 | Binchotan Charcoal | 1.85 | 1.2 | 1.1 | 2 | 1 | 0.6 |
| 2 | Binchotan Charcoal | 1.90 | 1.1 | 1.1 | 1 | 0.6 | 0.4 |
| 3 | Binchotan Charcoal | 1.95 | 1.2 | 1.1 | 0.8 | 0.6 | 0.2 |
| 101 | High-purity Graphite | 1.90 | 0.1 | 1.1 | 0 | 0 | 0 |
| 102 | High-purity Graphite & Common Charcoal | 1.70 | 0.24 | 1.1 | 0.6 | 0 | 0 |
| 103 | Common Charcoal | 1.60 | Diamond was unable to be produced | | | | |

### [Measurement of Diamond]

For the diamond of each sample, a content based on the number of atoms of ¹⁴C, a content based on the number of atoms of ¹³C, a content based on the number of atoms of phosphorus (P), a content based on the number of atoms of potassium (K), a content based on the number of atoms of calcium (Ca), a maximum diameter, a half-width of an X-ray diffraction rocking curve (shown as "Xrc" in Table 2), the number of defects confirmed in an X-ray topography image, an average of phase differences per unit thickness (shown as "Phase Difference" in Table 2), a half-width of a peak at a Raman shift of 1332 cm⁻¹ or more and 1333 cm⁻¹ or less in a Raman spectroscopy spectrum (shown as "Raman Half-width" in Table 2), a transmittance of light with a wavelength of 270 nm (shown as "270 nm Transmittance" in Table 2), a maximum peak wavelength of photoluminescence in a wavelength range from 400 nm to 700 nm when the diamond was irradiated with 325 nm excitation laser light (shown as "PL Peak" in Table 2), the presence or absence of two or more types of growth sectors different from each other, and the presence or absence of an inclusion were measured or confirmed. Specific measurement method and confirmation method are as described in the first embodiment. Table 1 and Table 2 show results.

### [Table 2]

**Table 2**

| Sample No. | Diamond | | | | | | | | |
|---|---|---|---|---|---|---|---|---|---|
| | Max. Diameter | Xrc | No. of Defects | Phase Difference | Raman Half-width | 270nm Transmittance | PL Peak | Growth Sector | Inclusion |
| | mm | sec. | defects/ cm² | nm/mm | cm⁻¹ | % | nm | present/ absent | present/ absent |
| 1 | 3.5 | 8 | 10 | 3 | 1.78 | 93 | 503 | present | absent |
| 2 | 3.0 | 6 | 5 | 1.2 | 1.72 | 96 | 503 | present | absent |
| 3 | 2.5 | 5 | 3 | 0.8 | 1.70 | 98 | 503 | present | absent |
| 101 | 3.0 | 11 | 150 | 12 | 1.85 | 80 | 530 | present | absent |
| 102 | 3.0 | 20 | 1000 | 25 | 3.20 | 60 | 530 | present | present |
| 103 | - | - | - | - | - | - | - | - | - |

The diamonds of Samples 1 to 3 correspond to the examples. The diamonds of Samples 1 to 3 have a content based on the number of atoms of ¹⁴C of 0.3 ppt or more and 3.0 ppt or less, and are diamonds in which carbon circulated from the atmosphere in recent years is fixed, which can contribute to the achievement of carbon neutrality.

The diamonds of Samples 101 to 102 were each produced using a carbon source produced from fossil fuel, and correspond to comparative examples.

Sample 103 used the common charcoal as a raw material, and the carbon raw material had a density of 1.6 g/cm³. At this density, the pressure in the synthesis environment was not stable, and a diamond was unable to be produced.

Although the embodiments and examples of the present disclosure have been described as described above, it is also initially expected to appropriately combine or variously modify the configurations of the above-described embodiments and examples.

It should be understood that the embodiments and examples disclosed herein are illustrative and non-restrictive in every respect. The scope of the present invention is defined by the scope of the claims, rather than the embodiments and examples described above, and is intended to include any modifications within the scope and meaning equivalent to the scope of the claims.

### REFERENCE SIGNS LIST

1 diamond, 2 insulator, 3 carbon source, 4 solvent metal, 5 seed crystal, 6 pressure medium, 7 graphite heater, 10 sample chamber.

## Claims

1. A diamond having a content based on a number of atoms of ¹⁴C of 0.3 ppt or more and 3.0 ppt or less.

2. The diamond according to claim 1, wherein the content based on the number of atoms of the ¹⁴C is 0.6 ppt or more and 1.5 ppt or less.

3. The diamond according to claim 1 or 2, having a content based on the number of atoms of ¹³C of 0.8% or more and 1.5% or less.

4. The diamond according to claim 3, wherein the content based on the number of atoms of the ¹³C is 1.0% or more and 1.2% or less.

5. The diamond according to any one of claims 1 to 4, wherein
the diamond contains at least one selected from the group consisting of phosphorus, potassium, and calcium, and
a total content based on the number of atoms of the phosphorus, the potassium, and the calcium in the diamond is 1 ppb or more.

6. The diamond according to any one of claims 1 to 5, wherein the diamond has a maximum diameter of 1 mm or more.

7. The diamond according to any one of claims 1 to 6, wherein
a half-width of an X-ray diffraction rocking curve of the diamond is 15 seconds or less, and
the half-width of the X-ray diffraction rocking curve is measured with CuKα rays in X-ray diffraction by a double crystal method, using a diamond crystal as a first crystal, with (004) planes being arranged in parallel.

8. The diamond according to any one of claims 1 to 7, wherein a number of defects confirmed in an X-ray topography image of the diamond is 100 defects/cm² or less.

9. The diamond according to any one of claims 1 to 8, wherein an average of phase differences per unit thickness of the diamond is 10 nm/mm or less.

10. The diamond according to any one of claims 1 to 9, wherein a half-width of a peak at a Raman shift of 1332 cm⁻¹ or more and 1333 cm⁻¹ or less in a Raman spectroscopy spectrum of the diamond is 3.0 cm⁻¹ or less.

11. The diamond according to any one of claims 1 to 10, wherein a transmittance of light with a wavelength of 270 nm of the diamond is 70% or more.

12. The diamond according to any one of claims 1 to 11, wherein, in a photoluminescence spectrum of the diamond, a maximum light emission peak exists within a range in wavelength of 490 nm or more and 510 nm or less.

13. The diamond according to any one of claims 1 to 12, wherein the diamond contains two or more types of growth sectors different from each other.

14. The diamond according to any one of claims 1 to 13, wherein the diamond does not contain an inclusion.
